# EUROPÄISCHE PATENTSCHRIFT

(11) **EP 2 491 629 B1**
(45) Veröffentlichungstag und Bekanntmachung des Hinweises auf die Patenterteilung: **07.06.2017**
(21) Anmeldenummer: 10784758.4
(22) Anmeldetag: 23.11.2010
(51) Int. Cl.: H01S 5/00, G02B 7/00, G02B 7/02, H01S 5/022

(54) **VERFAHREN ZUR HERSTELLUNG EINER LASERVORRICHTUNG**
MANUFACTURING METHOD OF A LASER DEVICE
PROCÉDÉ DE FABRICATION D'UN DISPOSITIF LASER

(30) Priorität: 23.12.2009 DE 102009055225
(43) Veröffentlichungstag der Anmeldung: 29.08.2012
(73) Patentinhaber: OSRAM GmbH, 80807 München (DE)
(72) Erfinder: SEIBERT, Claus, 93053 Regensburg (DE)
(86) Internationale Anmeldenummer: PCT/EP2010/068004
(87) Internationale Veröffentlichungsnummer: WO 2011/076506

(56) Entgegenhaltungen:
- EP-A1- 1 879 061
- EP-A1- 2 073 047
- WO-A1-2010/047147
- US-A- 5 033 052
- US-A- 5 351 264
- US-A- 5 758 950
- US-A1- 2006 222 042
- US-A1- 2008 050 151
- US-B2- 7 308 012

## Beschreibung

### Technisches Gebiet

Die vorliegende Erfindung betrifft ein Verfahren zur Herstellung einer Laservorrichtung mit einem zum Emittieren eines Laserstrahls ausgelegten Halbleiter-Laser und einer Linse, welche gegenüber dem Halbleiter lagejustiert wird. Weiter bezieht sich die Erfindung auf eine erfindungsgemäß hergestellte Laservorrichtung und die Verwendung einer solchen für Projektionsanwendungen.

### Stand der Technik

Bei einem Halbleiter-Laser erfolgt die Lichterzeugung durch Rekombinationsprozesse von Elektronen und Löchern am Übergang zwischen einem p- und einem n-dotierten Bereich, wobei mit der Wahl des Halbleitermaterials die emittierte Wellenlänge bestimmt werden kann, welche typischerweise in einem Bereich vom nahen Infrarot bis zum Ultravioletten liegt.

Bei den aus dem Stand der Technik bekannten Laservorrichtungen ist der Halbleiter-Laser in einem Metallgehäuse montiert, und zur Fokussierung des Laserstrahls ist eine Linse in dem Gehäuse vorgesehen. Diese liegt innenseitig an einer Durchtrittsöffnung im Gehäusedeckel an und wird mit einem Klemmsitz in dieser Position.

US 5 758 950A offenbart ein Verfahren zur Herstellung einer Halbleiterlaservorrichtung, bei dem eine Linse gegenüber dem Halbleiterlaser lagejustiert wird und dann an einem Linsenhalter fixiert wird.

US 2006/0222042 A offenbart ein Verfahren zur Herstellung einer Halbleiterlaservorrichtung, bei dem erst ein Linsenhalter positioniert und fixiert wird, dann eine Linse an dem Linsenhalter positioniert und fixiert wird.

### Darstellung der Erfindung

Der Erfindung liegt die Aufgabe zugrunde, ein Verfahren zur Herstellung einer Laservorrichtung mit einer gegenüber einem Halbleiter-Laser lagejustierten Linse anzugeben.

Erfindungsgemäß wird diese Aufgabe durch das Verfahren vom Anspruch 1 gelöst. Die Linse wird also derart ausgerichtet, dass die optische Achse parallel zur Ausbreitungsrichtung des Laserstrahls liegt. Die Parallelität wird hierbei auch noch innerhalb eines Winkelbereichs von bis zu 15° nach beiden Seiten als gegeben betrachtet, vorzugsweise bei einer Abweichung von bis zu 5°, besonders bevorzugt von bis zu 2°. Der Laserstrahl kann dabei auch konvergent beziehungsweise divergent verlaufen, sodass die Ausbreitungsrichtung ein Mittelwert einer Vielzahl von Richtungen sein kann.

Die mit der optischen Achse parallel zur Ausbreitungsrichtung des Laserstrahls orientierte Linse wird dann senkrecht zur Ausbreitungsrichtung des Laserstrahls verschoben und dabei von dem Laserstrahl durchdrungen. Auch der Begriff "senkrecht" wird im Rahmen der eben erwähnten Winkeltoleranz verstanden. Die Linse kann gegebenenfalls vor, während oder nach der Verschiebung senkrecht zur optischen Achse auch entlang der optischen Achse verschoben werden. Dabei kann der Linsenhalter einerseits mit gegenüber der Linse festgelegter Relativposition samt dieser verschoben werden, wobei dies auch nur entlang der Ausbreitungsrichtung oder senkrecht zu dieser erfolgen kann. Der Linsenhalter wird unabhängig von der Linse verschoben, sodass erst die Linse in die Endposition verschoben und dann der Linsenhalter angesetzt werden kann.

Die Linse wird dann nach der Verschiebung senkrecht zur und entlang der Ausbreitungsrichtung mit einer Fügeverbindung an dem Linsenhalter derart fixiert, dass die Verschiebbarkeit der Linse blockiert wird. Hierbei beschreibt der Begriff "Verschiebbarkeit", dass die Position der Linse zum Halbleiter-Laser verändert werden kann, beispielsweise indem die Linse mit einem Führungswerkzeug einer Führungsvorrichtung gehalten wird und mit diesem gegenüber dem Halbleiter-Laser verschoben wird. Die Verschiebbarkeit liegt dabei insbesondere auch vor, wenn die Linse gerade nicht verschoben wird und, weil sie in einem Haltewerkzeug gehalten wird, auch nur durch die Verschiebevorrichtung verschoben werden kann. Die Verschiebbarkeit kann dann mit einer Fügeverbindung durch fließfähiges Material, welches dann erstarrt, also beispielsweise ein Schweißen, Löten oder Kleben, zwischen Linse und Linsenhalter dauerhaft blockiert werden.

Eine Fügeverbindung im Sinne der Erfindung lagefixiert also zwei Bauteile relativ zueinander dauerhaft durch fließfähiges Material zwischen oder an den Bauteilen, welches zum Zweck der Fügeverbindung erstarrt. Das Material ist zunächst in einem fließfähigen, also mit gewisser Viskosität flüssigen, Zustand und kann vorzugsweise auch in diesem aufgebracht werden. Durch beispielsweise den Kontakt mit Luft oder einem anderen Gas beziehungsweise durch Beigabe eines chemischen Reaktionspartners, durch eine andere Wechselwirkung, beispielsweise mit Licht, oder durch Abkühlen geht das Material dann von dem fließfähigen in einen erstarrten Zustand über. In diesem ist das Material formfest, behält also im Wesentlichen seine Form, kann jedoch gegebenenfalls immer noch elastisch beziehungsweise viskoplastisch auf eine mechanische Beanspruchung reagieren; ist also nicht notwendigerweise formstarr. Die Verbindung ist dauerhaft in dem Sinne, dass die Bauteile nur nach einem Auftrennen der Fügeverbindung, etwa durch mechanische Einwirkung, insbesondere Gewalteinwirkung, Erhitzen oder chemische Behandlung, wieder relativ zueinander verschoben werden können.

Indem die Linse erfindungsgemäß zunächst senkrecht zur Ausbreitungsrichtung verschoben und erst dann lagefixiert wird, kann die Linse gegenüber dem Halbleiter-Laser auf diesen individuell abgestimmt mit hoher Präzision positioniert werden. Mit der Linsenposition können also beispielsweise montagebedingte Schwankungen in der Position des Halbleiter-Lasers ausgeglichen werden.

Bevorzugte Ausgestaltungen der Erfindung sind in den abhängigen Ansprüchen angegeben. Im Folgenden wird nicht mehr im Einzelnen zwischen der Beschreibung des Verfahrens zur Herstellung einer Laservorrichtung und dem Vorrichtungs- sowie Verwendungsaspekt der Erfindung unterschieden, die Offenbarung ist implizit im Hinblick auf sämtliche Kategorien zu verstehen.

Eine erste Ausgestaltung der Erfindung sieht vor, dass die Linse entlang der Ausbreitungsrichtung verschoben wird, aber nicht mehr, sobald die Verschiebbarkeit der Linse senkrecht zur Ausbreitungsrichtung blockiert ist. Der Linsenhalter ist hierbei vorzugsweise entlang der Ausbreitungsrichtung des Laserstrahls verschiebbar gelagert. Vorzugsweise ermöglicht die verschiebbare Lagerung entlang der Ausbreitungsrichtung eine Vielzahl von Relativpositionen zwischen dem Linsenhalter (und somit der Anlagefläche für die Linse) und dem Halbleiter-Laser, besonders bevorzugt durch eine geradlinige Bewegung. Eine verschiebbare Lagerung wäre jedoch auch durch beispielsweise eine Schraubverbindung gegeben, deren Drehachse in Ausbreitungsrichtung orientiert ist.

Die Relativposition zwischen der Anlagefläche für die Linse und dem Halbleiter-Laser kann unter Kontrolle durch eine Abstandsmessung, beispielsweise optisch, mechanisch oder elektrisch, eingestellt werden. Bevorzugt ist jedoch eine Einstellung der Relativposition zwischen der Anlagefläche und dem Halbleiter-Laser in Abhängigkeit von dem Laserstrahl nach Durchtritt durch die Linse, insbesondere in Abhängigkeit von dessen Durchmesser.

Entscheidend ist, dass die Position der Linse in der Richtung entlang der Ausbreitungsrichtung des Laserstrahls bereits festgelegt (wenn auch noch nicht notwendigerweise blockiert) ist, wenn die Verschiebbarkeit der Linse senkrecht zur Ausbreitungsrichtung blockiert wird.

In weiterer Ausgestaltung ist vorgesehen, dass die Verschiebbarkeit der Linse senkrecht zur Ausbreitungsrichtung gleichzeitig mit der Verschiebbarkeit entlang der Ausbreitungsrichtung blockiert wird. Dazu kann einerseits die Verschiebbarkeit des Linsenhalters entlang der Ausbreitungsrichtung bereits blockiert sein, sodass die Fügeverbindung zwischen Linsenhalter und Linse deren Verschiebbarkeit senkrecht zur Ausbreitungsrichtung und entlang dieser blockiert. Die Linse kann hierzu beispielsweise zweimal lagejustiert werden, sodass nach der ersten Lagejustage und in Abhängigkeit von dieser die Verschiebbarkeit des Linsenhalters blockiert wird und nach der zweiten Lagejustage die Fügeverbindung zwischen Linsenhalter und Linse hergestellt wird.

Andererseits kann die Fügeverbindung zwischen Linse und Linsenhalter auch gleichzeitig mit der Blockierung dessen Verschiebbarkeit entlang der Ausbreitungsrichtung erfolgen. Die Linse wird vorzugsweise zunächst derart verschoben, dass vorgegebene Sollwerte für Auslenkung und Durchmesser des Laserstrahls erreicht werden, die Linse also in die endgültige justierte Position gebracht wird. Dabei kann der Linsenhalter gleichzeitig oder sogar synchron mit der Linse verschoben werden oder auch unabhängig von dieser. Nachdem die Linse in die justierte Position gebracht ist, wird die Verschiebbarkeit von Linse und Linsenhalter gleichzeitig blockiert.

Bei einer weiteren Ausführungsform ist vorgesehen, dass die Linse bei der Verschiebung senkrecht zur Ausbreitungsrichtung entlang einer Plananlage an einer Stirnfläche des Linsenhalters geführt wird, wobei die Linse ansonsten frei ist. Sie ist also mit dem Linsenhalter allenfalls durch eine der Montage dienende Führungsvorrichtung verbunden, welche entfernt wird, nachdem die Verschiebbarkeit entlang der Plananlage blockiert ist. Der Linsenhalter umfasst somit vorzugsweise eine senkrecht zur Ausbreitungsrichtung orientierte flächige Anlage, an welcher beispielsweise die flächige Seite einer plankonkaven oder plankonvexen Linse eine Plananlage findet. Wird die Linse nun senkrecht zur Ausbreitungsrichtung verschoben, ändert sich hierbei aufgrund der Plananlage nicht die Position der Linse entlang der Ausbreitungsrichtung.

Dabei muss die Linse den Linsenhalter nicht notwendigerweise berühren. Es ist also auch möglich, dass das Führungswerkzeug den Linsenhalter berührt oder weder Führungswerkzeug noch Linse den Linsenhalter berühren und allein mit im Wesentlichen konstantem Abstand zu diesem verschoben werden. Entscheidend ist, dass eine Justage der Linsenposition senkrecht zur Ausbreitungsrichtung beispielsweise in Abhängigkeit von der Auslenkung des Laserstrahls vorgenommen werden kann, ohne dass hierbei der Durchmesser des Laserstrahls verändert wird. Neben einer Linse mit einer planen Seitenfläche kann beispielsweise auch eine Linse mit einem sich senkrecht zur optischen Achse erhebenden umlaufenden Vorsprung vorgesehen sein, wobei die dem Halbleiter-Laser zugewandte Flanke des Vorsprungs eine Plananlage am Linsenhalter findet. Wenngleich die Linse während der Montage plan am Linsenhalter anliegt und diesen gegebenenfalls sogar berührt, ist sie jedoch nur durch die der Montage dienende Führungsvorrichtung, welche nach der Montage entfernt wird, mit dem Linsenhalter verbunden. Der Begriff "verbunden" bezeichnet also eine für Führungszwecke ausreichende körperliche Verbindung, welche jedoch auch wieder ohne Gewalteinwirkung lösbar ist, also insbesondere keine Fügeverbindung. Linsenhalter und Linse werden also beispielsweise mit Führungswerkzeugen der Führungsvorrichtung durch einen Klemm-, Schraub- oder Unterdruckmechanismus gehalten, wenn die Linse entlang der Plananlage des Linsenhalters verschoben wird.

Bei einer anderen Ausführungsform ist vorgesehen, dass nach einer Verschiebung der Linse senkrecht zu und entlang der Ausbreitungsrichtung des Laserstrahls der Linsenhalter zur davon freien Linse geführt wird (und dabei also allenfalls durch eine der Montage dienende Führungsvorrichtung mit dieser verbunden ist, welche entfernt wird, nachdem die Fügeverbindung zwischen Linsenhalter und Linse hergestellt ist). Die Linse wird also beispielsweise mit einem Führungswerkzeug der Führungsvorrichtung in die gegenüber dem Halbleiter-Laser lagejustierte Position verschoben. Der Linsenhalter, welcher ebenfalls von einem Führungswerkzeug der Führungsvorrichtung gehalten sein kann, wird erst dann an die Linse herangeführt, wenn diese sich in der lagejustierten Position befindet und nicht weiter verschoben wird. Die Linse, der Linsenhalter sowie der Halbleiter-Laser samt einer möglichen Montagevorrichtung sind während der Justage also vorzugsweise allein über die Führungsvorrichtung miteinander verbunden, indem sie in deren Führungswerkzeugen gehalten sind.

Die Verschiebung der Linse ist besonders einfach möglich, wenn der Linsenhalter nicht mit verschoben wird, weil in diesem Fall während der Justage nur ein Führungswerkzeug bewegt werden muss. Der Linsenhalter wird erst nach der Positionierung an die Linse herangeführt, wobei dies dann beispielsweise mit einer Abstimmung zwischen den beiden Führungswerkzeugen, gegebenenfalls auch mit abstandsabhängiger Geschwindigkeitsanpassung, erfolgen kann.

Indem die Linse und der Linsenhalter in einem Bereich (der typischerweise zu erwartenden Relativverschiebung zueinander) vorzugsweise eine plane Anlagefläche haben, ist außer der Verschiebung des Linsenhalters entlang der Ausbreitungsrichtung zur Linse hin keine weitere Anpassung notwendig. Eine Fügeverbindung zwischen dem Linsenhalter und einer Führungsvorrichtung beziehungsweise einer Montagevorrichtung des Halbleiter-Lasers, wie beispielsweise einem Gehäuse, blockiert die Verschiebbarkeit des Linsenhalters entlang der Ausbreitungsrichtung, und eine zweite Fügeverbindung zwischen der Linse und dem Linsenhalter blockiert die Verschiebbarkeit der Linse senkrecht zur Ausbreitungsrichtung (und auch entlang der Ausbreitungsrichtung); die Linse ist durch die zwei Fügeverbindungen gegenüber dem Halbleiter-Laser lagefixiert.

Bei einer weiteren Ausführungsform ist vorgesehen, dass die Linse und der Linsenhalter durch Unterdruck an Führungswerkzeugen der Führungsvorrichtung gehalten werden. Auf diese Weise können der Linsenhalter und die Linse einerseits während der Positionierung sicher gehalten und geführt werden, solange die Verschiebbarkeit noch nicht blockiert ist. Andererseits können der Linsenhalter und die Linse dann einfach durch Wegnehmen des Unterdrucks wieder freigegeben werden, ohne eine mechanische Verbindung zu lösen, wodurch eine Beeinträchtigung der lagejustierten Position vermieden werden kann.

Die Führungswerkzeuge und die Linse beziehungsweise der Linsenhalter können dabei aneinander angepasst sein, sodass beispielsweise die Führungswerkzeuge an eine Wölbung der entsprechenden Außenfläche von Linsenhalter beziehungsweise Linse angepasste Ansaugöffnungen haben können. Andererseits können auch an der Linse beziehungsweise dem Linsenhalter plane Flächen vorgesehen sein, an welchen eine entsprechend plane Ansaugöffnung des Führungswerkzeuges eine flächige Anlage findet.

In weiterer Ausgestaltung ist vorgesehen, dass der Halbleiter-Laser in einem Gehäuse gelagert ist und die Verschiebbarkeit der Linse entlang der Ausbreitungsrichtung durch eine Fügeverbindung zwischen Gehäuse und Linsenhalter blockiert wird. Das Gehäuse kann dabei in einer Ebene senkrecht zur Ausbreitungsrichtung beispielsweise einen runden oder auch rechteckigen Querschnitt haben.

In weiterer Ausgestaltung ist dabei vorgesehen, dass der Linsenhalter ein rohrförmiger Körper mit einer solchen Durchgangsöffnung ist, dass der Linsenhalter vor dem Verschieben der Linse auf das Gehäuse aufschiebbar ist und vor dem Verschieben auf das Gehäuse geschoben wird. Die Durchgangsöffnung kann dabei in Abhängigkeit von dem Gehäuse einen in Ausbreitungsrichtung gesehen im Wesentlichen kreisförmigen oder auch rechteckigen Querschnitt haben und ist vorzugsweise so gestaltet, dass die Innenwandung des rohrförmigen Körpers beim Verschieben entlang der Ausbreitungsrichtung eine flächige Anlage an einer ihr gegenüberliegenden Außenseite des Gehäuses hat. Die flächige Anlage blockiert dabei im Rahmen eines für die Verschiebung entlang der Ausbreitungsrichtung notwenigen Bewegungsspielraumes die Verschiebbarkeit des Linsenhalters senkrecht zur Ausbreitungsrichtung. Bei dieser bevorzugten Ausgestaltung ist der Linsenhalter also (im Wesentlichen) allein entlang der Ausbreitungsrichtung verschiebbar (eine Rotationsbewegung, welche nicht den Abstand der Schwerpunkte ändert ist keine Verschiebung in diesem Sinne).

Bei einer weiteren Ausführungsform wird eine zweite Linse entlang der Ausbreitungsrichtung und senkrecht zu dieser verschoben und danach mit einer Fügeverbindung durch Aufbringen von fließfähigem Material, welches zum Zweck der Fügeverbindung erstarrt, an einem zweiten Linsenhalter fixiert. Der zweite Linsenhalter sowie die zweite Linse sind dabei in der zuvor beschriebenen Weise verschiebbar und durch eine Fügeverbindung in der Verschiebbarkeit blockierbar. Die Verschiebbarkeit des zweiten Linsenhalters kann durch eine Fügeverbindung zum ersten Linsenhalter oder zu einer Montagevorrichtung des Halbleiter-Lasers, beispielsweise einem Gehäuse, blockiert werden. Indem zwei Linsen vorgesehen sind, kann beispielsweise mit einer Zylinderlinse ein Laserstrahl mit in Ausbreitungsrichtung gesehen elliptischem Querschnittsprofil solchermaßen verändert werden, dass ein im Wesentlichen kreisrundes Querschnittsprofil resultiert. Ein elliptisches Querschnittsprofil entsteht beispielsweise durch eine Wellenleitergeometrie in dem Halbleiter-Laser selbst mit einem rechteckigen, insbesondere nicht quadratischen Profil. Mit einer zweiten in Ausbreitungsrichtung gesehen rotationsymmetrischen Linse können dann in zuvor beschriebener Weise Auslenkung und Durchmesser des (dann kreisrunden) Laserstrahls verändert werden.

Bei einer weiteren Ausführungsform wird der Laserstrahl während der Verschiebung der Linse auf einen optischen Sensor gelenkt. Der Laserstrahl kann dabei direkt von der Linse auf den Sensor fallen oder auch über eine weitere Optik auf diesen gelenkt werden. Der Sensor kann beispielsweise aus einer Diode aufgebaut sein, wobei mit einer Anordnung von zwei Dioden durch Differenzbildung die Auslenkung des Laserstrahl in einer Richtung gemessen werden kann. In analoger Weise kann mit vier Dioden oder einer Diode mit vier Quadranten (Vierquadrantendiode) die Auslenkung des Laserstrahls in einer Ebene beziehungsweise sein Durchmesser ermittelt werden. Dies ist ebenso mit einem CCD-Sensor (Charged-Coupled-Device) möglich, welcher aus einer Matrix lichtsensitiver Elemente besteht.

Ein optischer Sensor kann also abhängig von Auslenkung beziehungsweise Durchmesser des Laserstrahls elektrische Signale zur Verfügung stellen, welche dann beispielsweise einer automatisierten Steuer- oder Regeleinheit zugeführt oder für eine Arbeitskraft optisch ablesbar dargestellt werden können. Die elektrischen Signale, welche gegebenenfalls auch in elektronische umgewandelt werden können, werden also vorzugsweise als Steuer- oder Regelgröße bei der Verschiebung der Linse eingesetzt.

Bei einer weiteren Ausführungsform wird die Fügeverbindung durch einen Klebstoff hergestellt. Im Falle einer Klebeverbindung zwischen beispielsweise dem Linsenhalter und der Linse besteht dabei einerseits aufgrund der Adhäsion des Klebstoffs zum Linsenhalter und zur Linse und andererseits aufgrund der inneren Festigkeit des Klebstoffs eine feste (wenn auch nicht untrennbare) Verbindung zwischen dem Linsenhalter und der Linse.

Als Klebstoffe können dabei beispielsweise lösemittelhaltige Klebstoffe, Dispersionsklebstoffe oder auch chemisch härtende Klebstoffe eingesetzt werden. Der Klebstoff kann neben Kunststoffmaterial auch Komponenten wie beispielsweise Metall oder Glas enthalten und ferner in seiner Zusammensetzung dahingehend optimiert sein, dass ein Schrumpfen beim Aushärten minimiert wird.

Die räumliche Anordnung des Klebstoffes erfolgt vorzugsweise solchermaßen symmetrisch, dass die im Falle eines Schrumpfens vom Klebstoff auf die jeweiligen Komponenten ausgeübten Kräfte sich gegenseitig im Wesentlichen aufheben (dies gilt auch allgemein für die Fügeverbindungen). Im Falle einer in Ausbreitungsrichtung gesehen runden Linse kann also beispielsweise über deren gesamten Kreisumfang durchgehend Klebstoff vorliegen oder es können äquidistante Klebstoffpunkte entlang des Kreisumfangs vorgesehen sein.

Der Klebstoff kann dabei insbesondere ein UV-härtender Klebstoff sein. Der UV-härtende Klebstoff, beispielsweise auf Acrylatbasis, kann dabei zunächst vorgehärtet werden. Die Führungswerkzeuge können vorzugsweise bereits nach dem Vorhärten von der Linse und dem Linsenhalter genommen werden, sodass die Führungsvorrichtung dann bereits wieder für die Justage der nächsten Laservorrichtung zur Verfügung steht. Das vorgehärtete Bauteil kann dann durchgehärtet werden, was auch bei anderer Wellenlänge beziehungsweise Lampenleistung erfolgen kann.

In weiterer Ausgestaltung besteht der Linsenhalter aus einem UV-durchlässigen Material, und die Klebeverbindung zwischen Gehäuse und Linsenhalter wird durch ein Bestrahlen mit UV-Licht ausgehärtet. Für den Linsenhalter, der im Gegensatz zum Material der Fügeverbindung bereits vor dem Verschieben der Linse in einem formfesten Zustand ist, ist also vorzugsweise ein UV-durchlässiges Kunststoffmaterial oder Quarzglas vorgesehen. Bei der UV-Bestrahlung kann somit eine Schattenbildung durch den Linsenhalter verringert werden. In Abhängigkeit von der Geometrie des Gehäuses und des Linsenhalters kann dabei vorzugsweise mit einer Bestrahlung aus einer einzigen Richtung der Kleber vollständig vor- beziehungsweise ausgehärtet werden. Besonders bevorzugt werden die Klebeverbindungen zwischen Gehäuse und Linsenhalter sowie zwischen diesem und der Linse gleichzeitig vor- beziehungsweise ausgehärtet.

Bei einer weiteren Ausgestaltung wird das fließfähige Material durch eine zusätzliche Öffnung im Linsenhalter an das Gehäuse gebracht. Damit kann eine Fügeverbindung zwischen Gehäuse und Linsenhalter auch dann realisiert werden, wenn beispielsweise die der Anlagefläche für die Linse gegenüberliegende Außenfläche des Linsenhalters für ein Aufbringen des fließfähigen Materials schlecht zugänglich ist. Die zusätzliche Öffnung erstreckt sich dabei quer zur Durchgangsöffnung, jedoch nicht notwendigerweise mit einem Winkel von 90°, sondern mit einem beliebigen Winkel zwischen 0° und 180°.

Die Erfindung bezieht sich auch auf eine Laservorrichtung mit einem Halbleiter-Laser, einer Linse und einem Linsenhalter, wobei die Linse in einem Verfahren nach einem der vorstehenden Ansprüche gegenüber dem Halbleiter-Laser lagejustiert und mit einer Fügeverbindung durch zuvor fließfähiges Material, welches erstarrt ist, am Linsenhalter fixiert ist.

Des Weiteren bezieht sich die Erfindung auch auf die Verwendung einer erfindungsgemäß hergestellten Laservorrichtung in einem Laser-RGB-Modul. Ein solches Modul kann beispielsweise als Bestandteil eines Projektionsgeräts eingesetzt werden, insbesondere eines tragbaren Projektionsgeräts. Dabei sind auch höchste Anforderungen an die Auflösung, beispielsweise Video Graphics Array (VGA) oder Extended Video Graphics Array (EVGA), möglich. Die drei Grundfarben, Rot, Grün und Blau, werden jeweils durch eine Laserstrahlquelle erzeugt und durch eine entsprechende Optik derart überlagert, dass ein einziger Strahl beziehungsweise Spot entsteht. Damit hierbei die entsprechend hohen Auflösungen erreicht werden können, darf der Versatz der Strahlen in dieser Reihenfolge zunehmend bevorzugt 100 Mikrometer, 75 Mikrometer, 50 Mikrometer und 25 Mikrometer nicht überschreiten. Eine erfindungsgemäß hergestellte Laservorrichtung mit einer gegenüber dem Halbleiter-Laser lagejustierten Linse, welche sowohl die Auslenkung als auch den Durchmesser des Laserstrahls entsprechend anpasst, ist deshalb beispielsweise für eine solche Anwendung besonders geeignet.

### Kurze Beschreibung der Zeichnungen

Im Folgenden wird die Erfindung anhand von Ausführungsbeispielen näher erläutert, wobei die einzelnen Merkmale auch in anderen Kombinationen erfindungswesentlich sein können und sich implizit auf alle Kategorien der Erfindung beziehen.
- Fig. 1: zeigt eine mit einer Klebeverbindung an einem Linsenhalter befestigte Linse.
- Fig. 2: zeigt eine Verschiebung der Linse in Abhängigkeit von der Auslenkung des Laserstrahls.
- Fig. 3: zeigt Querschnittsprofile verschiedener Linsenhalter.
- Fig. 4: zeigt Laservorrichtungen mit zwei Linsenhaltern.
- Fig. 5: zeigt ein Detail aus Figur 4.

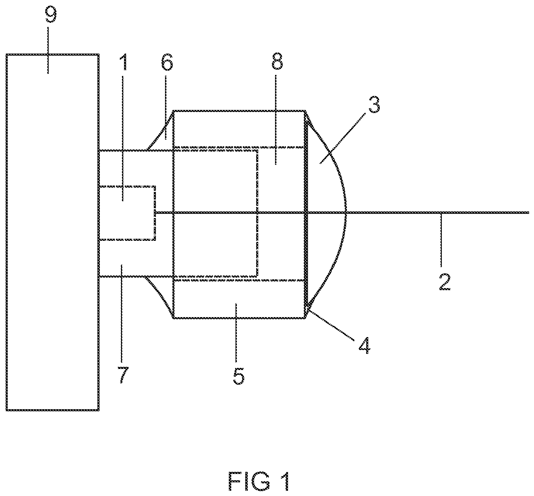

Figur 1 zeigt eine Laservorrichtung mit einem Halbleiter-Laser 1, der einen Laserstrahl 2 emittiert. Dabei wird der Laserstrahl 2 mit einer Linse 3 fokussiert, welche mit einer Fügeverbindung 4 an einem Linsenhalter 5 befestigt ist. Der Linsenhalter 5 ist mit einer weiteren Fügeverbindung 6 an einem Gehäuse 7 des Halbleiter-Lasers fixiert und auf diese Weise auch gegenüber dem Halbleiter-Laser 1 lagefixiert.

Der Linsenhalter 5 hat eine Durchgangsöffnung 8, in welche das Gehäuse 7 ein Stück weit eingeschoben ist, wobei der Linsenhalter vor dem Anbringen der Fügeverbindung 6 bis zu einer Anlage an einem Montagesockel 9 am Gehäuse 7 verschiebbar war. Durch die Anlage der Ausnehmung 8 an einer Außenfläche des Gehäuses 7 ist der Linsenhalter dabei in Bezug auf Richtungen senkrecht zur Ausbreitungsrichtung des Laserstrahls 2 lagefixiert. Nach der Justage der Linsenposition entlang der Ausbreitungsrichtung des Laserstrahls 2 und senkrecht zu dieser kann der zuvor auf das Gehäuse 7 aufgeschobene Linsenhalter 5 an die Linse 3 herangeführt werden. Indem die Linse 3 eine Plananlage am Linsenhalter 5 findet, kann die Verschiebung des Linsenhalters 5 entlang der Ausbreitungsrichtung des Laserstrahls 2 dabei unabhängig von der Position der Linse 3 in Richtungen senkrecht zur Ausbreitungsrichtung des Laserstrahls 2 erfolgen. Nachdem der Linsenhalter 5 an die lagejustierte Linse 3 herangeführt ist, wird mit UVhärtendem Klebstoff eine Fügeverbindung 4 zwischen Linsenhalter 5 und Linse 3 sowie zwischen Linsenhalter 5 und Gehäuse 7 hergestellt. Da der Linsenhalter 5 aus einem UV-durchlässigen Material besteht, kann die Fügeverbindung zwischen Linsenhalter und Gehäuse durch Bestrahlung mit UV-Licht aus einer der Ausbreitungsrichtung des Laserstrahls 2 entgegengesetzten Richtung ausgehärtet werden.

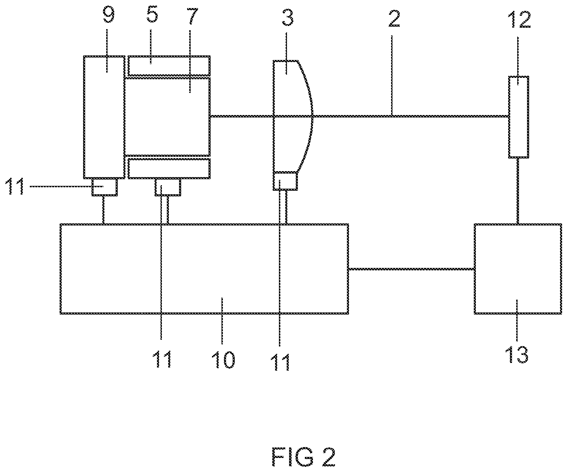

Figur 2 zeigt eine Führungsvorrichtung 10 mit drei Führungswerkzeugen 11, in welchen der Halbleiter-Laser 1 mit einem Gehäuse 7, der Linsenhalter 5 und die Linse 3 gehalten werden, wobei letztere beide durch Unterdruck an den Führungswerkzeugen 11 gehalten werden. Der Laserstrahl 2 tritt durch die Linse 3 und fällt dann auf einen Sensor 12, mit welchem Auslenkung und Durchmesser des Laserstrahls 2 gemessen werden. Der Sensor 12 gibt entsprechende elektrische Signale an die Auswerteeinheit 13, welche die Positionierung der Linse 3 über die Führungsvorrichtung 10 regelt.

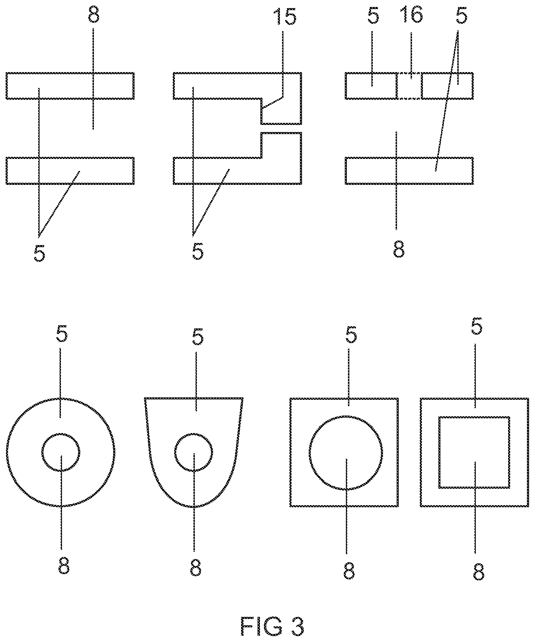

Figur 3 zeigt Querschnitte durch verschiedene Linsenhalter 5, wobei die Querschnittebenen sowohl die Ausbreitungsrichtung des Laserstrahls 2 enthalten (obere Reihe) als auch senkrecht zu dieser Richtung orientiert sind (untere Reihe). Der Linsenhalter 5 kann dabei eine gerade durchgehende Durchgangsöffnung 8 haben oder eine sich solchermaßen verjüngende Durchgangsöffnung 8, dass ein Anschlag 15 entsteht. Ein solcher Anschlag 15 kann dann vor dem Anbringen der Fügeverbindung 6 zwischen Linsenhalter 5 und Gehäuse 7 am Gehäuse 7 anliegen. In der rechten oberen Querschnittsform ist ferner eine zusätzliche sich quer zur Ausbreitungsrichtung zu der Durchgangsöffnung 8 hin erstreckende Durchgangsöffnung 16 vorgesehen. Durch diese kann auch dann Klebstoff zwischen Gehäuse 7 und Linsenhalter 5 gebracht werden, wenn die der Anlagefläche für die Linse 3 gegenüberliegende Seitenfläche des Linsenhalters 5 schlecht zugänglich ist.

Der Linsenhalter 5 kann eine runde Außenfläche haben, an welche ein Unterdruckwerkzeug 11 dann entsprechend angepasst ist oder kann auch eine abgeflachte Außenfläche beziehungsweise generell flache Außenseiten aufweisende Form haben, sodass ein Unterdruck erzeugendes Führungswerkzeug 11 plan anliegt. Die Ausnehmung 8 kann dabei an die Gehäusegeometrie angepasst sein, also rund, insbesondere kreisrund, oder eckig, insbesondere quadratisch, ausgeführt sein.

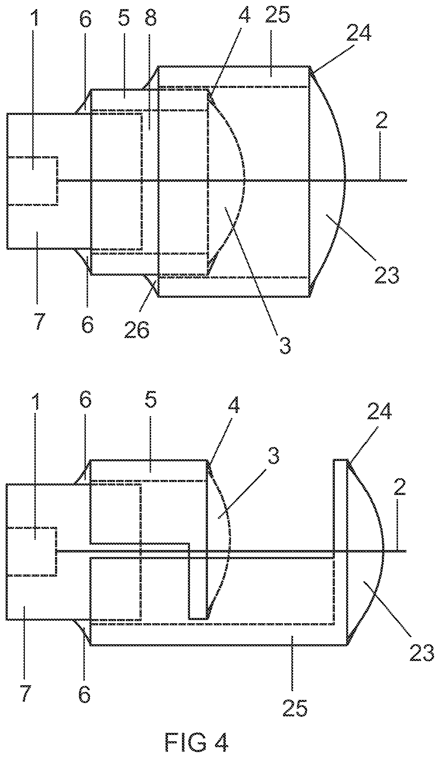

In Figur 4 sind erfindungsgemäß hergestellte Laservorrichtungen mit jeweils zwei Linsenhaltern sowie zwei Linsen gezeigt. In der oberen Darstellung ist der zweite Linsenhalter 25 mit einer Fügeverbindung 26 am ersten Linsenhalter 5 fixiert, welcher mit einer Fügeverbindung 6 am Gehäuse 7 des Halbleiter-Lasers 1 fixiert ist. Der Durchmesser der ersten Linse 3 ist solchermaßen kleiner als der Außendurchmesser des ersten Linsenhalters 5, dass im Rahmen der bei der Justage üblichen Positionierung die Fügeverbindung 4 den Linsenhalter 5 senkrecht zur Ausbreitungsrichtung nicht überragt. Der zweite Linsenhalter 25 ist somit auch nach der Montage der ersten Linse 3 durch eine flächige Anlage an der Außenseite des ersten Linsenhalters 5 entlang der Ausbreitungsrichtung verschiebbar.

Die untere Darstellung zeigt zwei Linsenhalter, die als zueinander komplementäre Hälften ausgebildet sind. Der erste Linsenhalter 5 liegt dabei nicht vollständig umlaufend am Gehäuse 7 an, und der zweite Linsenhalter 25 ist ebenfalls mit einer Fügeverbindung 6 am Gehäuse 7 befestigt. Auf diese Weise kann eine Laservorrichtung mit zwei Linsenhaltern bezogen auf Richtungen senkrecht zur Ausbreitungsrichtung besonders platzsparend ausgeführt werden, sodass zwei Laservorrichtungen mit geringerem Abstand zueinander in einem Modul platziert werden können.

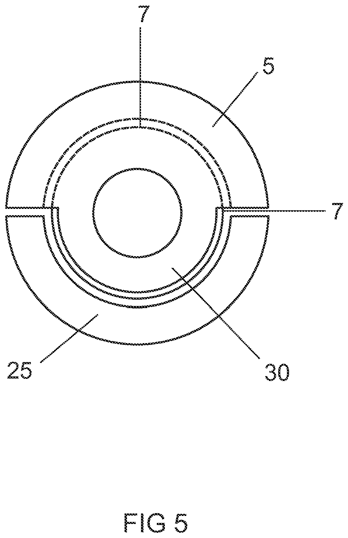

Figur 5 zeigt in Ausbreitungsrichtung gesehen eine flächige Anlage 30 des ersten Linsenhalters 5 aus der unteren Darstellung in Figur 4. Die erste Linse 3 kann entlang der flächigen Anlage 30 senkrecht zur Ausbreitungsrichtung verschoben und mit einer umlaufenden Fügeverbindung 4 in der Verschiebbarkeit blockiert werden (nicht gezeigt). Da die flächige Anlage 30 das Gehäuse 7 in Richtungen senkrecht zur Ausbreitungsrichtung nur teilweise überragt, kann der zweite Linsenhalter 25 an der flächigen Anlage 30 solchermaßen vorbeigeführt sein, dass der zweite Linsenhalter entlang der Ausbreitungsrichtung verschiebbar ist, bis die Verschiebbarkeit durch eine Fügeverbindung 6 zum Gehäuse 7 blockiert wird.

## Patentansprüche

1. Verfahren zur Herstellung einer Laservorrichtung mit einem Halbleiter-Laser (1), welcher zum Emittieren eines Laserstrahls (2) ausgelegt ist,
und einer Linse (3), welche gegenüber dem Halbleiter-Laser (1) lagejustiert wird,
indem die Linse (3) zuerst senkrecht zur und entlang der Ausbreitungsrichtung des Laserstrahls (2) verschoben und dabei von dem Laserstrahl (2) durchdrungen wird,
wobei die optische Achse der Linse (3) parallel zur Ausbreitungsrichtung des Laserstrahls (2) liegt, nach der Verschiebung der Linse (3) senkrecht zur und entlang der Ausbreitungsrichtung, die Linse in der so erreichten Endposition gehalten wird, der Linsenhalter (5) zur Linse geführt wird und dabei nur durch eine der Montage dienende Führungsvorrichtung (10) mit dieser verbunden ist, die Linse (3) danach mit einer Fügeverbindung (4) durch fließfähiges Material, welches zum Zweck der Fügeverbindung erstarrt, an dem Linsenhalter (5) derart fixiert wird,
dass die Verschiebbarkeit der Linse (3) senkrecht zur Ausbreitungsrichtung des Laserstrahls (2) blockiert wird, und wobei
die Führungsvorrichtung (10) entfernt wird, nachdem die Fügeverbindung (4) zwischen Linsenhalter (5) und Linse (3) hergestellt ist.

2. Verfahren nach Anspruch 1, bei dem die Linse (3) entlang der Ausbreitungsrichtung verschoben wird, aber nicht mehr, sobald die Verschiebbarkeit der Linse (3) senkrecht zur Ausbreitungsrichtung blockiert ist.

3. Verfahren nach Anspruch 2, bei dem die Verschiebbarkeit der Linse (3) senkrecht zur Ausbreitungsrichtung gleichzeitig mit der Verschiebbarkeit entlang der Ausbreitungsrichtung blockiert wird.

4. Verfahren nach einem der vorstehenden Ansprüche, bei dem die Linse (3) und der Linsenhalter (5) durch Unterdruck an Führungswerkzeugen (11) einer Führungsvorrichtung (10) gehalten werden.

5. Verfahren nach einem der vorstehenden Ansprüche, bei dem der Halbleiter-Laser (1) in einem Gehäuse (7) gelagert ist und die Verschiebbarkeit der Linse (3) entlang der Ausbreitungsrichtung durch eine Fügeverbindung (6) zwischen Gehäuse (7) und Linsenhalter (5) durch fließfähiges Material, welches zum Zweck der Fügeverbindung erstarrt, blockiert wird.

6. Verfahren nach Anspruch 5, bei dem der Linsenhalter (5) ein rohrförmiger Körper mit einer solchen Durchgangsöffnung (8) ist, dass der Linsenhalter (5) auf das Gehäuse (7) aufschiebbar ist und vor dem Verschieben der Linse (3) auf das Gehäuse (7) geschoben wird.

7. Verfahren nach einem der vorstehenden Ansprüche, bei dem eine zweite Linse (23) entlang der Ausbreitungsrichtung und senkrecht zu dieser verschoben und dann mit einer Fügeverbindung (24) durch fließfähiges Material, welches zum Zweck der Fügeverbindung erstarrt, an einem zweiten Linsenhalter (25) fixiert wird.

8. Verfahren nach einem der vorstehenden Ansprüche, bei dem der Laserstrahl (2) während der Verschiebung der Linse (3) auf einen optischen Sensor (12) gelenkt wird.

9. Verfahren nach einem der vorstehenden Ansprüche, bei dem die Fügeverbindung durch einen, insbesondere UVhärtenden, Klebstoff hergestellt wird.

10. Verfahren nach Anspruch 9 in Verbindung mit einem der Ansprüche 5 und 6, bei dem der Linsenhalter (5) aus einem UV-durchlässigen Material besteht und die Klebeverbindung zwischen Gehäuse (7) und Linsenhalter (5) durch Bestrahlen mit UV-Licht ausgehärtet wird.

11. Verfahren nach Anspruch 6 in Verbindung mit Anspruch 9 oder 10, bei dem das fließfähige Material durch eine zusätzliche Öffnung (16) im Linsenhalter (5) an das Gehäuse (7) gebracht wird.

12. Verfahren zur Herstellung eines Laser-RGB-Moduls mit einer Laservorrichtung unter Durchführung eines Verfahrens nach einem der vorstehenden Ansprüche.

13. Verfahren zur Herstellung eines Projektionsgeräts unter Durchführung eines Verfahrens nach Anspruch 12.

14. Verfahren zur Herstellung eines tragbaren Projektionsgeräts unter Durchführung eines Verfahrens nach Anspruch 13.

## Claims

1. Method for producing a laser device having a semiconductor laser (1) which is configured to emit a laser beam (2), and having a lens (3) which is position-adjusted with respect to the semiconductor laser (1), wherein the lens (3) is first displaced perpendicular to and along the propagation direction of the laser beam (2) and in so doing is penetrated by the laser beam (2), wherein the optical axis of the lens (3) is situated parallel to the propagation direction of the laser beam (2), and, after displacing the lens (3) perpendicular to and along the propagation direction, the lens is held in the end position thus reached, the lens holder (5) is guided towards the lens and in so doing is connected only by and to a guide device (10) serving for mounting, the lens (3) is subsequently fixed to the lens holder (5) by a joint (4) produced by free-flowing material which solidifies for the purpose of forming the joint, in such a way that the displaceability of the lens (3) perpendicular to the propagation direction of the laser beam (2) is blocked, and wherein the guide device (10) is removed after the joint (4) between lens holder (5) and lens (3) is produced.

2. Method according to Claim 1, in which the lens (3) is displaced along the propagation direction, but no longer as soon as the displaceability of the lens (3) perpendicular to the propagation direction is blocked.

3. Method according to Claim 2, in which the displaceability of the lens (3) perpendicular to the propagation direction is blocked simultaneously with the displaceability along the propagation direction.

4. Method according to one of the preceding claims, in which the lens (3) and the lens holder (5) are held by negative pressure on guide tools (11) of a guide device (10).

5. Method according to one of the preceding claims, in which the semiconductor laser (1) is mounted in a housing (7) and the displaceability of the lens (3) along the propagation direction is blocked by a joint (6) between housing (7) and lens holder (5) produced by free-flowing material which solidifies for the purpose of forming the joint.

6. Method according to Claim 5, in which the lens holder (5) is a tubular body with such a through-opening (8) that the lens holder (5) can be pushed onto the housing (7) and is pushed onto the housing (7) prior to displacing the lens (3).

7. Method according to one of the preceding claims, in which a second lens (23) is displaced along the propagation direction and perpendicular thereto and then is fixed to a second lens holder (25) by a joint (24) produced by free-flowing material which solidifies for the purpose of forming the joint.

8. Method according to one of the preceding claims, in which the laser beam (2) is directed onto an optical sensor (12) during the displacement of the lens (3).

9. Method according to one of the preceding claims, in which the joint is produced by an, in particular UV-curing, adhesive.

10. Method according to Claim 9 in conjunction with either of Claims 5 and 6, in which the lens holder (5) consists of a UV-permeable material and the adhesive bond between housing (7) and lens holder (5) is cured by irradiation with UV light.

11. Method according to Claim 6 in conjunction with Claim 9 or 10, in which the free-flowing material is applied to the housing (7) through an additional opening (16) in the lens holder (5).

12. Method for producing a laser RGB module with a laser device by implementing a method according to one of the preceding claims.

13. Method for producing a projection device by implementing a method according to Claim 12.

14. Method for producing a portable projection device by implementing a method according to Claim 13.

## Revendications

1. Procédé de fabrication d'un dispositif laser avec un laser à semi-conducteur (1) conçu pour émettre un faisceau laser (2), et
une lentille (3) dont la position par rapport au laser à semi-conducteur (1) est ajustée,
en décalant la lentille (3) d'abord perpendiculairement à et le long de la direction de propagation du faisceau laser (2) de façon qu'elle soit traversée par le faisceau laser (2),
l'axe optique de la lentille (3) étant parallèle à la direction de propagation du faisceau laser (2),
une fois la lentille (3) décalée perpendiculairement à et le long de la direction de propagation, la lentille étant maintenue dans la position finale ainsi atteinte, un porte-lentille (5) étant amené à la lentille à laquelle il n'est relié que par un dispositif de guidage (10) servant au montage,
la lentille (3) étant ensuite fixée au porte-lentille (5) par une liaison par assemblage (4) au moyen d'un matériau fluide qui se solidifie pour créer ladite liaison de manière à bloquer le décalage de la lentille (3) perpendiculairement à la direction de propagation du faisceau laser (2),
et le dispositif de guidage (10) étant retiré une fois que la liaison par assemblage (4) entre le porte-lentille (5) et la lentille (3) est établie.

2. Procédé selon la revendication 1, dans lequel la lentille (3) est décalée le long de la direction de propagation jusqu'à ce que le décalage de la lentille (3) perpendiculairement à la direction de propagation soit bloqué.

3. Procédé selon la revendication 2, dans lequel le décalage de la lentille (3) perpendiculairement à la direction de propagation est bloqué en même temps que le décalage le long de la direction de propagation.

4. Procédé selon l'une des revendications précédentes, dans lequel la lentille (3) et le porte-lentille (5) sont maintenus par dépression sur des outils de guidage (11) d'un dispositif de guidage (10).

5. Procédé selon l'une des revendications précédentes, dans lequel le laser à semi-conducteur (1) est logé dans un boîtier (7), et le décalage de la lentille (3) le long de la direction de propagation est bloqué par une liaison par assemblage (6) entre le boîtier (7) et le porte-lentille (5) au moyen d'un matériau fluide qui se solidifie pour créer ladite liaison.

6. Procédé selon la revendication 5, dans lequel le porte-lentille (5) est un corps tubulaire doté d'un orifice de passage (8) tel que le porte-lentille (5) peut être glissé sur le boîtier (7) et est glissé sur le boîtier (7) avant de décaler la lentille (3).

7. Procédé selon l'une des revendications précédentes, dans lequel une seconde lentille (23) est décalée le long de la direction de propagation et perpendiculairement à celle-ci puis fixée sur un second porte-lentille (25) par une liaison par assemblage (24) au moyen d'un matériau fluide qui se solidifie pour créer ladite liaison.

8. Procédé selon l'une des revendications précédentes, dans lequel le faisceau laser (2) est dirigé sur un capteur optique (12) pendant le décalage de la lentille (3).

9. Procédé selon l'une des revendications précédentes, dans lequel la liaison d'assemblage est réalisée par un adhésif, notamment un adhésif durcissant aux UV.

10. Procédé selon la revendication 9 en association avec l'une des revendications 5 ou 6, dans lequel le porte-lentille (5) est constitué d'un matériau perméable aux UV, et l'assemblage collé entre le boîtier (7) et le porte-lentille (5) est durci par irradiation avec de la lumière UV.

11. Procédé selon la revendication 6 en association avec la revendication 9 ou 10, dans lequel le matériau fluide est amené au boîtier (7) par un orifice supplémentaire (16) ménagé dans le porte-lentille (5).

12. Procédé de fabrication d'un module laser RGB avec un dispositif laser comprenant la mise en oeuvre d'un procédé selon l'une des revendications précédentes.

13. Procédé de fabrication d'un appareil de projection comprenant la mise en oeuvre d'un procédé selon la revendication 12.

14. Procédé de fabrication d'un appareil de projection portatif comprenant la mise en oeuvre d'un procédé selon la revendication 13.
